(19) Europäisches Patentamt
European Patent Office
Office européen des brevets

(11) Veröffentlichungsnummer: **0 440 924 A1**

## (12) EUROPÄISCHE PATENTANMELDUNG

(21) Anmeldenummer: **90123744.6**

(22) Anmeldetag: **10.12.90**

(51) Int. Cl.⁵: **H01L 29/08**

(30) Priorität: **05.02.90 DE 4003387**

(43) Veröffentlichungstag der Anmeldung:
**14.08.91 Patentblatt 91/33**

(84) Benannte Vertragsstaaten:
**CH DE FR GB IT LI SE**

(71) Anmelder: **EUPEC Europäische Gesellschaft für Leistungshalbleiter mbH & Co. KG**
**Max-Planck-Strasse 5**
**W-4788 Warstein/Belecke(DE)**

(72) Erfinder: **Bechteler, Martin, Dr.**

**Nelkenweg 10**
**W-8011 Kirchheim(DE)**
Erfinder: **Gross, Wolfgang, Dr.**
**Erdinger Strasse 18**
**W-8059 Moosinning(DE)**
Erfinder: **Willmeroth, Armin**
**Richard-Wagner-Strasse 10**
**W-8060 Dachau(DE)**

(74) Vertreter: **Fuchs, Franz-Josef, Dr.-Ing. et al**
**Postfach 22 13 17**
**W-8000 München 22(DE)**

(54) **GTO-Thyristor mit Kurzschlüssen.**

(57) GTO-Thyristoren sind im allgemeinen zum Verbessern des Ausschaltverhaltens mit anodenseitigen Kurzschlüssen versehen. Bei realen GTO-Thyristoren haben die Kurzschlußgebiete eine den Katodenemitterzonen ähnliche Form und sind diesen gegenüberliegend angeordnet. Das damit verbundene Justieren kann entfallen, wenn die Kurzschlußzonen (31 bis 34) in Form eines geometrischen Musters angeordnet sind, das vom geometrischen Muster der Katodenemitterzonen (3) verschieden ist und jeder Katodenemitterzone (3) mindestens ein Teil einer Kurzschlußzone gegenüberliegt.

## FIG 1

EP 0 440 924 A1

## GTO-THYRISTOR MIT KURZSCHLÜSSEN

Die Erfindung bezieht sich auf einen GTO-Thyristor mit einem Halbleiterkörper mit mehreren, in Form eines ersten geometrischen Musters angeordneten Katodenemitterzonen, mit mindestens einer Anodenemitterzone, in der mindestens eine Kurzschlußzone vom der Anodenemitterzone entgegengesetzten Leitungstyp angeordnet ist.

Solche GTO-Thyristoren sind z. B. in der EP-200 861 A1 beschrieben worden. Weitere GTO-Thyristoren dieser Art sind Gegenstand der Druckschriften IEEE IAS 1985 Annual Meeting, October 6-11, S. 871-875, Conf. Record of the 1986 IEEE-IAS Annual Meeting, September 28-October 3, S. 388-392. Den erwähnten Konferenzberichten ist zu entnehmen, daß die Kurzschlußzonen unterhalb der Katodenemitterzonen angeordnet sind. Bei im Handel erhältlichen GTO-Thyristoren dieser Art sind Teile der Kurzschlußzonen und die Anodenemitterzone auf die Katodenemitterzonen justiert. Dies erfordert eine genaue Justierung der anodenseitigen Masken relativ zu den katodenseitigen Masken und damit einen relativ hohen Aufwand.

Der Erfindung liegt die Aufgabe zugrunde, einen GTO-Thyristor der erwähnten Gattung derart weiterzubilden, daß eine genaue Justierung der anodenseitigen Kurzschlußzonen bezüglich der Katodenemitterzonen entbehrlich ist.

Dieses Ziel wird dadurch erreicht, daß mehrere Kurzschlußzonen vorgesehen und in der Anodenemitterzone in Form eines zweiten regelmäßigen geometrischen Musters angeordnet sind, daß das zweite Muster vom ersten Muster verschieden ist und daß jeder Katodenemitterzone mindestens ein Teil einer Kurzschlußzone gegenüberliegt.

Weiterbildungen der Erfindung sind Gegenstand der Unteransprüche. Gemäß einer von der obengenannten Lösung unabhängigen Alternative wird die Aufgabe dadurch gelöst, daß eine einzige Kurzschlußzone vorgesehen ist, daß die Kurzschlußzone in Form eines zweiten Musters ausgebildet ist, daß das zweite Muster vom ersten Muster verschieden ist und daß jeder Katodenemitterzone mindestens ein Teil der Kurzschlußzone gegenüberliegt.

Die Erfindung wird anhand einiger Ausführungsbeispiele in Verbindung mit den FIG 2 bis 4 näher erläutert. Es zeigen

FIG 1 die Aufsicht auf ein Teil eines Halbleiterkörpers eines GTO-Thyristors nach dem Stand der Technik

FIG 2 die teilweise Aufsicht auf ein Teil eines Halbleiterkörper eines GTO-Thyristors nach einem ersten Ausführungsbeispiel

FIG 3 die Aufsicht auf ein Teil eines Halbleiterkörpers eines GTO-Thyristors nach einem zweiten Ausführungsbeispiel und

FIG 4 eine ähnliche Aufsicht auf ein drittes Ausführungsbeispiel.

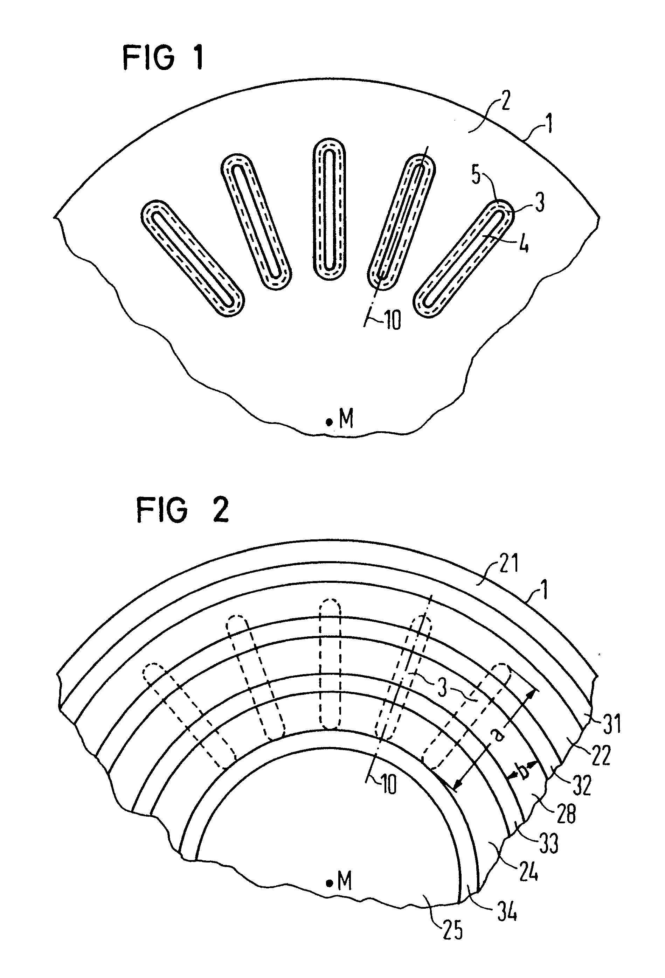

In FIG 1 ist der Halbleiterkörper eines bekannten GTO-Thyristors mit 1 bezeichnet. Die dem Betrachter zugewandte Seite des Halbleiterkörpers zeigt eine Kurzschlußzone 2. In der Zone 2 sind streifenförmige Anodenemitterzonen 5 vom entgegengesetzten Leitungstyp angeordnet. In den Zonen 5 treten Kurzschlußzonen 4 an die Oberflächen, die den gleichen Leitungstyp wie die Zone 2 haben. Auf der Katodenseite des Halbleiterkörpers sind streifenförmige Katodenemitterzonen 3 angeordnet. Diese Katodenemitterzonen sind gestrichelt eingezeichnet. Die Längsachsen 10 der Zonen 3, 4, 5 liegen radial zum Mittelpunkt M des Halbleiterkörpers. Die Zonen liegen außerdem auf einem zu M zentrischen Ring.

Für eine bestimmungsgemäße Wirkung der Kurzschlußzonen 4 sind diese auf die Katodenemitterzonen 3 zentriert, d. h. ihre Längsachsen 10 fallen vorzugsweise zusammen. Dies erfordert, wie eingangs erwähnt, einen hohen Justieraufwand.

Beim ersten Ausführungsbeispiel der Erfindung nach FIG 2 sind die Katodenemitterzonen 3 ebenso wie nach der Anordnung nach FIG 1 auf einem zentrisch zum Mittelpunkt M des Halbleiterkörpers 1 liegenden Ring angeordnet. Ihre Längsachsen liegen wieder radial zu M. Anodenseitig sind mehrere ringförmige Kurzschlußzonen 31, 32, 33, 34 vorgesehen. Diese liegen vorzugsweise zentrisch zu M. Entsprechend hat der GTO-Thyristor mehrere Anodenemitterzonen 21, 22, 23, 24 und 25. Die ringförmigen Kurzschlußzonen haben einen Abstand b voneinander, der kleiner ist als die Länge a der Katodenemitterzonen 3. Damit ist gewährleistet, daß die Wirkung der anodenseitigen Kurzschlußzonen auch bei ungenauer Justierung der anodenseitigen Maske relativ zur katodenseiten Maske gesichert ist.

Das Ausführungsbeispiel nach FIG 2 ist vereinfacht dargestellt. In realen GTO-Thyristoren sind mehrere Ringe von Katodenemitterzonen 3 auf dem Halbleiterkörper untergebracht. Pro Katodenemitterring können auch mehr als die gezeigten vier Kurzschlußzonen 32 bis 34 vorgesehen sein, man kann hier jedem Katodenemitterring z. B. 10 bis 20 ringförmige Kurzschlußzonen zuordnen.

Die Erfindung ist nicht auf die in FIG 2 gezeigte radialsymmetrische Struktur beschränkt. So können die ringförmigen Kurzschlußzonen auch mit Katodenemitterzonen zusammenwirken, die in Form eines regelmäßigen rechteckigen Rasters angeordnet sind.

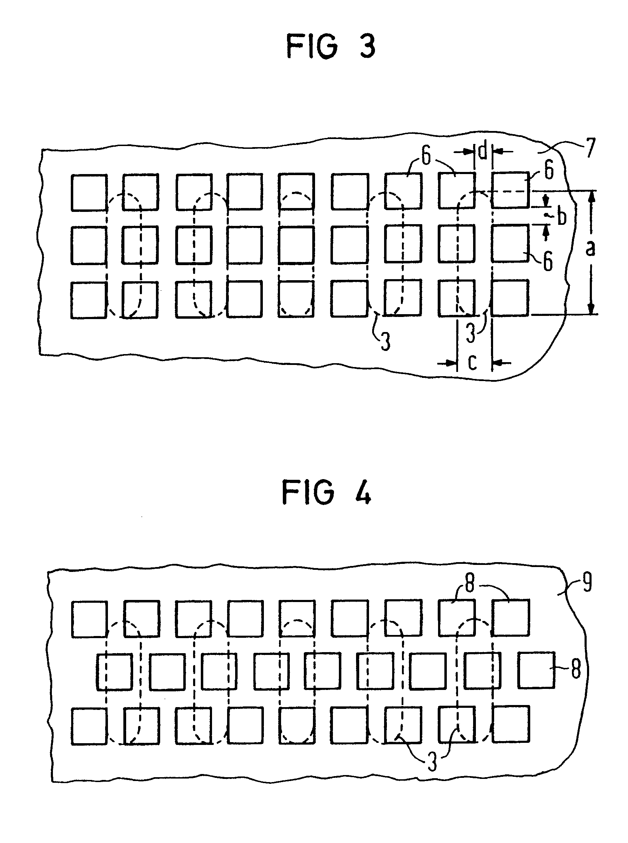

In FIG 3 ist eine solche Anordnung mit gegenüber dem Ausführungsbeispiel nach FIG 2 abweichender Geometrie dargestellt. Außerdem ist hier nur eine einzige Kurzschlußzone 7 vorgesehen, die ein regelmäßiges Gitter bildet. In diesem Gitter sind Anodenemitterzonen 6 inselförmig angeordnet. Die Katodenemitterzonen sind wieder mit 3 bezeichnet. Die Kurzschlußzone ist derart gestaltet, daß bei einer Dejustierung oder ungenauen Justierung der anodenseitigen zu den katodenseitigen Masken immer ein Teil jeder der Katodenemitterzonen 3 von einem Teil der Kurzschlußzone 7 bedeckt ist. Hierzu sind die vertikalen Abstände b der Anodenemitterzonen 6 kleiner als die Länge a der Katodenemitterzonen 3 und die horizontalen Abstände d der Anodenemitterzonen 6 kleiner als die Breite c der Katodenemitterzonen 3.

Das Ausführungsbeispiel nach FIG 4 unterscheidet sich von dem nach FIG 3 dadurch, daß hier mehrere Kurzschlußzonen 8 vorgesehen sind, die in einer einzigen Anodenemitterzone 9 angeordnet sind und ein regelmäßiges geometrisches Muster bilden. Zusätzlich kann alternierend jede zweite Reihe von Kurzschlußzonen 8 gegenüber den vertikal benachbarten Reihen versetzt angeordnet sein. Für die vertikalen und horizontalen Abstände der Kurzschlußzonen 8 in Bezug auf die Länge bzw. Breite der Katodenemitterzone 3 gilt entsprechendes wie für das Ausführungsbeispiel nach FIG 3.

Die in Verbindung mit FIG 4 beschriebene Versetzung jeder zweiten Reihe von Kurzschlußzonen 8 gegenüber den vertikal benachbarten Reihen kann entsprechend auch im Ausführungsbeispiel nach FIG 3 angewandt werden. Es ist auch möglich, die Anordnung der Kurzschlußzonen und der Anodenemitterzonen nach FIG 3 und 4 mit einer radialsymmetrischen Anordnung der Katodenemitterzonen nach FIG 2 zu kombinieren.

**Patentansprüche**

1. GTO-Thyristor mit einem Halbleiterkörper mit mehreren, in Form eines ersten geometrischen Musters angeordneten Katodenemitterzonen, mit mindestens einer Anodenemitterzone, in der mindestens eine Kurzschlußzone vom der Anodenemitterzone entgegengesetzten Leitungstyp angeordnet ist, **dadurch gekennzeichnet,** daß mehrere Kurzschlußzonen vorgesehen und in der Anodenemitterzone in Form eines zweiten regelmäßigen geometrischen Musters angeordnet sind, daß das zweite Muster vom ersten Muster verschieden ist und daß jeder Katodenemitterzone mindestens ein Teil einer Kurzschlußzone gegenüberliegt.

2. GTO-Thyristor nach Anspruch 1, **dadurch gekennzeichnet,** daß die Katodenemitterzonen (3) streifenförmig ausgebildet, bezüglich ihrer Längsachsen (10) radial auf dem Halbleiterkörper (1) und mindestens in einem zum Halbleiterkörper konzentrisch liegenden Kreis angeordnet sind und daß die Anodenemitterzonen (21-25) und die Kurzschluß zonen (31-34) konzentrisch zum Halbleiterkörper (1) liegende Ringe sind.

3. GTO-Thyristor nach Anspruch 1, **dadurch gekennzeichnet,** daß eine einzige Anodenemitterzone (9) vorgesehen ist, und daß die Kurzschlußzonen (8) in der Anodenemitterzone (9) in der Form eines regelmäßigen Rasters angeordnet sind.

4. GTO-Thyristor mit einem Halbleiterkörper mit mehreren, in Form eines ersten geometrischen Musters angeordneten Katodenemitterzonen, mit mindestens einer Anodenemitterzone, in der mindestens eine Kurzschlußzone von der Anodenemitterzone entgegengesetzten Leitungstyp angeordnet ist, **dadurch gekennzeichnet,** daß eine einzige Kurzschlußzone (7) und mehrere Anodenemitterzonen (6) vorgesehen sind, daß die Kurzschlußzone in Form vom eines zweiten Muster ausgebildet ist, daß das zweite Muster vom ersten Muster verschieden ist und daß jeder Katodenemitterzone mindestens ein Teil der Kurzschlußzone gegenüberliegt.

5. GTO-Thyristor nach Anspruch 4, **dadurch gekennzeichnet,** daß die Kurzschlußzone (7) ein regelmäßiges Gitter bildet.

## FIG 1

## FIG 2

## FIG 3

## FIG 4

**Europäisches Patentamt**

**EUROPÄISCHER RECHERCHENBERICHT**

Nummer der Anmeldung

**EP 90 12 3744**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN Band 12, Nr. 124 (E-601)(2971), 16. April 1988; & JP - A - 62250669 (FUJI ELECTRIC) 31.10.1987 * Zusammenfassung; Abbildung * | 1,3 | H 01 L 29/08 |
| Y | idem | 2,4,5 | |
| X | EP-A-0 151 019 (WESTINGHOUSE BRAKE AND SIGNAL COMPANY LTD.) * Seite 1, Zeile 30 - Seite 2, Zeile 17; Seite 3, Zeile 30 - Seite 4, Zeile 1; Figuren * | 1 | |
| Y | | 2 | |
| X | PATENT ABSTRACTS OF JAPAN Band 12, Nr. 324 (E-653)(3171), 2. September 1988; & JP - A - 6390166 (MITSUBISHI ELECTRIC) 21.04.1988 * Zusammenfassung; Abbildungen * | 1,3 | |
| Y | EP-A-0 014 080 (HITACHI) * Abbildung 1 * | 4,5 | |

RECHERCHIERTE SACHGEBIETE (Int. Cl.5)

H 01 L

Der vorliegende Recherchenbericht wurde für alle Patentansprüche erstellt

| Recherchenort | Abschlußdatum der Recherche | Prüfer |
|---|---|---|
| Berlin | 08 Februar 91 | JUHL A. |